# EUROPEAN PATENT APPLICATION

(11) **EP 4 130 875 A1**
(43) Date of publication of application: **08.02.2023**
(21) Application number: 21775738.4
(22) Date of filing: 18.01.2021
(51) Int. Cl.: G03F 7/00, G03F 7/004, G03F 7/033, G03F 7/037

(54) **LIGHT-SENSITIVE RESIN ORIGINAL PRINTING PLATE FOR LETTERPRESS PRINTING**

(30) Priority: 26.03.2020 JP 2020056822
(71) Applicant: TOYOBO CO., LTD., Osaka-shi Osaka 5300001 (JP)
(72) Inventor: KAWASHIMA, Wataru, Okayama-shi, Okayama 704-8194 (JP)
(74) Representative: Müller-Boré & Partner Patentanwälte PartG mbB
(86) International application number: PCT/JP2021/001428
(87) International publication number: WO 2021/192536

(57) **Abstract**

The present invention aims to provide a photosensitive resin printing original plate for letterpress printing having excellent swelling resistance to an oil-based ink containing an ester-based compound.

A photosensitive resin printing original plate for letterpress printing having a photosensitive resin layer formed of a photosensitive resin composition containing at least a polymer compound (A), a dibasic acid diester (B) represented by the following general formula (I), a photopolymerizable compound (C), and a photopolymerization initiator (D), in which the content of the dibasic acid diester (B) in the photosensitive resin composition is 2.5 to 15 mass%: 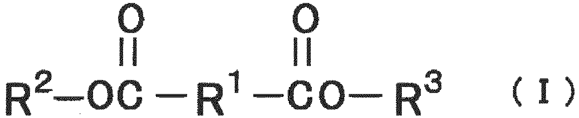 (where R¹ represents a divalent aliphatic hydrocarbon group having 2 to 8 carbon atoms, a divalent aromatic hydrocarbon group having 6 to 14 carbon atoms, or a divalent aliphatic cyclic hydrocarbon group having 4 to 14 carbon atoms, and R² and R³ may be the same as or different from each other and each represents a linear or branched aliphatic hydrocarbon group having 1 to 12 carbon atoms) .

## Description

### Technical Field

The present invention relates to a photosensitive resin printing original plate for letterpress printing having excellent swelling resistance to an oil-based ink, especially a photosensitive resin printing original plate for letterpress printing having excellent swelling resistance to an oil-based ink containing an ester compound to be used for fabric tag printing.

### Background Art

As to a method for producing a printing plate by developing a printing original plate, a method using a developer containing an organic solvent has been conventionally performed. Due to the problem of the working environment, however, a method for producing a printing plate by performing the development with water or with an aqueous developer prepared by adding a surfactant or the like to water has been proposed (cf. for example, Patent Documents 1 to 3).

These conventional proposals usually disclose that a plasticizer is contained in the printing original plate so as to reduce hardness and so as to improve rebound resilience. On the other hand, when the plasticizer is contained, mechanical strength of the obtained printing plate becomes insufficient, and thus printing durability lowers, whereby cracks of the printing plate at the time of long-run printing, relief image defects, and the like occur.

In addition, in the application of printing a fabric tag, an oil-based ink containing an ester compound is used. Conventional printing plates absorb the ink applied during printing to cause swelling, whereby lines on a printed matter are thickened when long-run printing is performed.

### Prior Art Documents

### Patent Documents

Patent Document 1: Japanese Patent Application Laid-Open (JP-A) No. 198058/91
Patent Document 2: WO 2014/034213
Patent Document 3: Japanese Patent Application Laid-Open (JP-A) No. 2003-287887

### Disclosure of the Invention

### Problem that the Invention is to Solve

The present invention has been made to solve the problems of the prior art, and an object thereof is to provide a photosensitive resin printing original plate for letterpress printing having excellent swelling resistance to an oil-based ink, especially a photosensitive resin printing original plate for letterpress printing having excellent swelling resistance to an oil-based ink containing an ester-based compound.

### Means for Solving the Problem

As a result of intensive studies to achieve such an object, the present inventors have found that when a specific amount of a dibasic acid diester is contained in a photosensitive resin layer constituting a printing original plate, a printing original plate excellent in swelling resistance to an oil-based ink is obtained, whereby the present invention has been completed.

In summary, the present invention has the following configurations (1) to (6).
(1) A photosensitive resin printing original plate for letterpress printing having a photosensitive resin layer formed of a photosensitive resin composition containing at least a polymer compound (A), a dibasic acid diester (B) represented by the following general formula (I), a photopolymerizable compound (C), and a photopolymerization initiator (D), in which the content of the dibasic acid diester (B) in the photosensitive resin composition is 2.5 to 15 mass%: 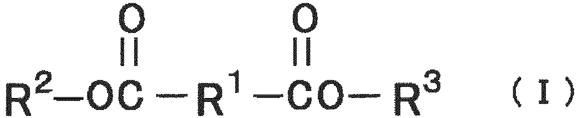 (where R¹ represents a divalent aliphatic hydrocarbon group having 2 to 8 carbon atoms, a divalent aromatic hydrocarbon group having 6 to 14 carbon atoms, or a divalent aliphatic cyclic hydrocarbon group having 4 to 14 carbon atoms, and R² and R³ may be the same as or different from each other and each represents a linear or branched aliphatic hydrocarbon group having 1 to 12 carbon atoms).
(2) The photosensitive resin printing original plate for letterpress printing according to (1), wherein the dibasic acid diester (B) is at least one selected from the group consisting of succinic acid diester, glutaric acid diester, adipic acid diester, pimelic acid diester, suberic acid diester, azelaic acid diester, sebacic acid diester, and phthalic acid diester.
(3) The photosensitive resin printing original plate for letterpress printing according to (1) or (2), wherein the polymer compound (A) is a latex having a butadiene skeleton and/or an isoprene skeleton.
(4) The photosensitive resin printing original plate for letterpress printing according to (3), wherein the latex is a polybutadiene latex, a styrene-butadiene copolymer latex, an acrylonitrile-butadiene copolymer latex, a methyl methacrylate-butadiene copolymer latex, a polyisoprene latex, or a latex obtained by further copolymerizing acrylic acid or methacrylic acid with any of the above copolymer latexes.
(5) The photosensitive resin printing original plate for letterpress printing according to (4), wherein the latex is at least one water-dispersible latex selected from the group consisting of a polybutadiene latex, a styrene-butadiene copolymer latex, an acrylonitrile-butadiene copolymer latex, a methyl methacrylate-butadiene copolymer latex, and a latex obtained by further copolymerizing acrylic acid or methacrylic acid with any of the above copolymer latexes.
(6) The photosensitive resin printing original plate for letterpress printing according to (1) or (2), wherein the polymer compound (A) is a polyamide resin composed of a polyamide and/or a polyamide block copolymer, and/or a partially saponified polyvinyl acetate resin.

### Advantages of the Invention

According to the present invention, it is possible to provide a photosensitive resin printing original plate for letterpress printing in which the swelling of a printing plate due to absorption of the ink is small even when an oil-based ink containing an ester-based compound is used, and thus the line thickening of an image on a printed matter hardly occurs even when long-run printing is performed.

### Best Mode for Carrying Out the Invention

The photosensitive resin printing original plate for letterpress printing of the present invention has a photosensitive resin layer formed of a photosensitive resin composition containing at least a polymer compound (A), a dibasic acid diester (B) represented by the following general formula (I), a photopolymerizable compound (C), and a photopolymerization initiator (D). Hereinafter, each component of the photosensitive resin composition will be described.

The polymer compound (A) is not particularly limited as long as it is used in this field, but from the viewpoint of suitability as a letterpress printing original plate,
(i) a latex having a butadiene skeleton and/or an isoprene skeleton;
(ii) a polyamide resin composed of a polyamide and/or a polyamide block copolymer, and/or
(iii) a partially saponified polyvinyl acetate resin is preferred.

As to the latex having a butadiene skeleton and/or an isoprene skeleton (i), it may be appropriately selected from conventionally known latexes. For example, a polybutadiene latex, a styrene-butadiene copolymer latex, an acrylonitrile-butadiene copolymer latex, a methyl methacrylate-butadiene copolymer latex, and a polyisoprene latex may be used. These latexes may be modified with (meth)acrylic, carboxy, silicone, fluorine, or the like as desired. As to these latexes, a large number of various synthetic latexes and natural latexes are commercially available, and an appropriate latex may be selected from them.

Among them, a water-dispersible latex containing a butadiene skeleton in the molecular chain is preferably used from the viewpoint of hardness and rubber elasticity. As to such water-dispersible latex, a polybutadiene latex, a styrene-butadiene copolymer latex, an acrylonitrile-butadiene copolymer latex, a methyl methacrylate-butadiene copolymer latex, and a copolymer latex obtained by copolymerizing acrylic acid or methacrylic acid with any of the above copolymer are specifically preferable, and a polybutadiene latex and an acrylonitrile-butadiene copolymer latex are more preferable.

As to the polyamide resin composed of a polyamide and/or a polyamide block copolymer (ii), it can be a polymer compound containing 50 mass% or more, and preferably 70 mass% or more, of a structural unit constituted of an amide bond in the form of a block in the molecule. Examples thereof include polyether amides, polyether ester amides, tertiary nitrogen-containing polyamides, ammonium salt type tertiary nitrogen atom-containing polyamides, and addition polymers of an amide compound having one or more amide bonds and an organic diisocyanate compound. Among them, ammonium salt type tertiary nitrogen atom-containing polyamides are preferable. When a tertiary nitrogen atom-containing polyamide and an ammonium salt type tertiary nitrogen atom-containing polyamide are contained, the developability is improved by adding an organic acid. Examples of the organic acid include, but are not limited to, acetic acid, lactic acid, and methacrylic acid.

As to the partially saponified polyvinyl acetate resin (iii), it is not particularly limited as long as the component is used in this field, but from the viewpoint of image reproducibility of a letterpress printing plate, a partially saponified polyvinyl acetate resin having a saponification degree of 70 to 95 mol% and an average polymerization degree of 1,500 to 3,400 is preferable.

The blending amount of the polymer compound (A) is preferably 30 to 80 mass%, and more preferably 40 to 75 mass%, in the photosensitive resin composition. If it is less than the above lower limit, the strength as a printing plate may be insufficient, and if it exceeds the above upper limit, it may take time for water development.

The dibasic acid diester (B) is a compound obtained by esterifying an organic acid having a structure capable of dissociating two protons in water and is specifically a compound represented by the following general formula (I): 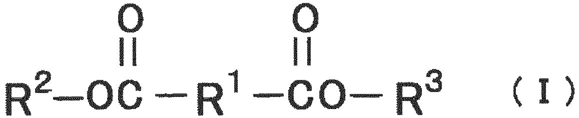 (where R¹ represents a divalent aliphatic hydrocarbon group having 2 to 8 carbon atoms, a divalent aromatic hydrocarbon group having 6 to 14 carbon atoms, or a divalent aliphatic cyclic hydrocarbon group having 4 to 14 carbon atoms, and R² and R³ may be the same as or different from each other and each represents a linear or branched aliphatic hydrocarbon group having 1 to 12 carbon atoms).

Specific examples of the dibasic acid diester having such a structure include dimethyl oxalate, dimethyl malonate, dimethyl succinate, dimethyl glutarate, dimethyl tartrate, dimethyl adipate, dimethyl glutamate, dimethyl sebacate, dimethyl hexafluorosilicate, diethyl oxalate, diethyl malonate, diethyl succinate, diethyl glutarate, diethyl tartrate, diethyl adipate, diethyl glutamate, diethyl sebacate, diethyl hexafluorosilicate, dimethyl phthalate, diethyl phthalate, dibutyl phthalate, bis(2-ethylhexyl) phthalate, diisononyl phthalate, ethyl phthalyl ethyl glycolate, dibutyl adipate, diisobutyl adipate, bis(2-ethylhexyl) adipate, diisononyl adipate, diisodecyl adipate, bis[2-(2-butoxyethoxy)ethyl] adipate, bis(2-ethylhexyl) azelate, and dibutyl sebacate. Each of these may be used singly, or two or more kinds thereof may be used in combination.

Among them, succinic acid diester, glutaric acid diester, adipic acid diester, pimelic acid diester, suberic acid diester, azelaic acid diester, sebacic acid diester, and phthalic acid diester are preferable.

By blending such a dibasic acid diester in the photosensitive resin layer, a printing plate excellent in swelling resistance to an oil-based ink containing an ester compound can be obtained. In particular, the swelling of the printing plate occurs when the ester compound in the oil-based ink containing the ester compound is absorbed into the photosensitive resin layer during printing. In the present invention, the absorption of the ester compound can be suppressed by incorporating the dibasic acid diester.

The blending amount of the dibasic acid diester (B) needs to be 2.5 to 15 mass%, and preferably 3.0 to 10 mass%, in the photosensitive resin composition. The dibasic acid diester has an effect of suppressing the phenomenon that the ester compound contained in the oil-based ink is absorbed by the photosensitive resin layer. Accordingly, when the amount is less than the above lower limit, the swelling resistance to the oil-based ink is poor. On the other hand, when the amount is more than the above upper limit, printing durability at the time of long-run printing is poor due to deterioration in physical properties caused by the dibasic acid diester, which is not preferable.

The photopolymerizable compound (C) is preferably a photopolymerizable oligomer, particularly preferably a conjugated diene-based ethylenic polymer in which an ethylenic unsaturated group is bonded to an end and/or a side chain of a conjugated diene-based polymer, and has a number average molecular weight of 500 or more and 10,000 or less.

The conjugated diene-based polymer constituting the conjugated diene-based ethylenic polymer is constituted of a homopolymer of a conjugated diene unsaturated compound or a copolymer of a conjugated diene unsaturated compound and a monoethylenic unsaturated compound. Examples of the homopolymer of a conjugated diene unsaturated compound or the copolymer of a conjugated diene unsaturated compound and a monoethylenic unsaturated compound include a butadiene polymer, an isoprene polymer, a chloroprene polymer, a styrene-chloroprene copolymer, an acrylonitrile-butadiene copolymer, an acrylonitrile-isoprene copolymer, a methyl methacrylate-isoprene copolymer, an acrylonitrile-isoprene copolymer, a methyl methacrylate-isoprene copolymer, a methyl methacrylate-chloroprene copolymer, a methyl acrylate-butadiene copolymer, a methyl acrylateisoprene copolymer, a methyl acrylate-chloroprene copolymer, a methyl acrylate-chloroprene copolymer, an acrylonitrile-butadiene-styrene copolymer, and an acrylonitrilechloroprene-styrene copolymer. Among them, from the viewpoint of rubber elasticity and photocurability, a butadiene polymer, an isoprene polymer, and an acrylonitrile-butadiene copolymer are preferable, and a butadiene polymer and an isoprene polymer are particularly preferable.

A method for introducing the ethylenic unsaturated group into the end and/or side chain of the conjugated diene-based polymer is not particularly limited, and examples thereof include (i) a method in which a monoethylenic unsaturated carboxylic acid such as (meth)acrylic acid is ester-bonded, by a dehydration reaction, to a hydroxy group at the end of a hydroxyterminated conjugated diene-based polymer obtained by using hydrogen peroxide as a polymerization initiator, or a method in which a monoethylenic unsaturated carboxylic acid alkyl ester such as methyl (meth)acrylate and ethyl (meth)acrylate is ester-bonded to the above hydroxy group by a transesterification reaction, and (ii) a method in which an ethylenic unsaturated alcohol such as allyl alcohol and vinyl alcohol is allowed to react with a conjugated diene-based polymer obtained by copolymerizing a conjugated diene compound and an ethylenic unsaturated compound containing an unsaturated carboxylic acid (ester) at least partially.

As the photopolymerizable compound (C) component, an alkyl methacrylate can be used in addition to the above-described photopolymerizable oligomer. The alkyl methacrylate is preferably a linear alkyl methacrylate having 8 to 18 carbon atoms.

Specific examples thereof include alkyl (meth)acrylates such as methyl (meth)acrylate, ethyl (meth)acrylate, propyl (meth)acrylate, butyl (meth)acrylate, isoamyl (meth)acrylate, 2-ethylhexyl (meth)acrylate, lauryl (meth)acrylate, and stearyl (meth)acrylate; cycloalkyl (meth)acrylates such as cyclohexyl (meth)acrylate; halogenated alkyl (meth)acrylates such as chloroethyl (meth)acrylate and chloropropyl (meth)acrylate; alkoxyalkyl (meth)acrylates such as methoxyethyl (meth)acrylate, ethoxyethyl (meth)acrylate, and butoxyethyl (meth)acrylate; and phenoxyalkyl (meth)acrylates such as phenoxyethyl (meth)acrylate and nonylphenoxyethyl (meth)acrylate. Particularly preferable examples include n-lauryl methacrylate, alkyl (C12 or 13) methacrylate, tridecyl methacrylate, and alkyl (C12 to 15) methacrylate.

The blending amount of the photopolymerizable compound (C) is preferably 5 to 70 mass%, and more preferably 10 to 60 mass%, in the photosensitive resin composition. If it is less than the above lower limit, the time required for curing by ultraviolet irradiation may become significantly long, and if it exceeds the above upper limit, the depth of concave lines, concave characters, and the like may become extremely shallow.

As to the photopolymerization initiator (D), any conventionally known photopolymerization initiator can be used as long as it can polymerize a polymerizable carbon-carbon unsaturated groups by light, and particularly, a photopolymerization initiator having a function of producing a radical by self-decomposition or hydrogen abstraction by light absorption is preferably used. Examples thereof include benzoin alkyl ethers, benzophenones, anthraquinones, benzyls, acetophenones, and diacetyls. The blending amount of the photopolymerization initiator (D) is preferably in the range of 0.1 to 50 parts by mass, and more preferably in the range of 0.3 to 10 parts by mass, with respect to 100 parts by mass of the polymer compound (A). If it is less than the above lower limit, the initiation efficiency may decrease and the image reproducibility may be poor, and if it exceeds the above upper limit, the sensitivity may be too high and it may be difficult to control the exposure time.

A plasticizer can be further added to the photosensitive resin composition. The plasticizer is not particularly limited as long as it has a property of generally softening the plate material, but a plasticizer having good compatibility with the polymer compound (A) and the photopolymerizable compound (C) is preferable.

In addition, in order to increase the thermal stability of the photosensitive resin composition, a conventionally known polymerization inhibitor can be added to the photosensitive resin composition. Preferable examples of the polymerization inhibitor include phenols, hydroquinones, and catechols. The blending amounts thereof are generally in the range of 0.001 to 5 mass% with respect to the entire photosensitive resin composition.

In addition, examples of other optional components include dyes, pigments, viscosity modifiers, antifoaming agents, ultraviolet absorbers, fragrances, aggregation inhibitors, and surfactants.

Next, a method for producing the printing original plate of the present invention will be described. First, the above-described components are provided and mixed so as to produce a photosensitive resin composition. Next, the obtained photosensitive resin composition is formed into a layer so as to provide a photosensitive resin layer. Specific examples thereof include a method in which the components of the photosensitive resin composition are mixed using an extruder, a kneader, or the like, and then a photosensitive resin layer having a desired thickness is formed by hot press molding, calendering treatment, or extrusion molding. To the obtained photosensitive resin layer, a support such as polyester may be provided on the side opposite to the surface which will constitute a relief, in order to maintain the accuracy as a printing plate. The photosensitive resin layer exhibits tackiness depending on the composition thereof. Accordingly, a flexible film layer that can be developed in an aqueous system may be provided on the surface of the photosensitive resin layer, in order to improve the contact property with a transparent image carrier (negative film) to be overlaid thereon and in order to enable the image carrier to be reused. The support and the flexible film layer can be brought into close contact with the photosensitive resin layer by roll lamination after formation of the sheet. In addition, it is also possible to obtain a photosensitive resin layer with high accuracy by heating and pressing after lamination.

Next, a method for obtaining a printing plate from the printing original plate of the present invention will be described. First, the photosensitive resin layer in the printing original plate of the present invention is irradiated with light through a transparent image carrier, so that the irradiated portion is photocured so as to form an image. Thereafter, the non-irradiated portion is removed (developed) using an aqueous developer so as to obtain a relief (printing plate).

Examples of an active ray source used for the photocuring include a low-pressure mercury lamp, a highpressure mercury lamp, an ultraviolet fluorescent lamp, a carbon arc lamp, a xenon lamp, a zirconium lamp, and sunlight.

As to the aqueous developer, water alone or water mixed with a surfactant such as a nonionic surfactant and an anionic surfactant, and a pH adjusting agent, a cleaning aid, or the like as necessary can be used.

Specific examples of the nonionic surfactant include polyoxyalkylene alkyl or alkenyl ethers, polyoxyalkylene alkyl or alkenyl phenyl ethers, polyoxyalkylene alkyl or alkenyl amines, polyoxyalkylene alkyl or alkenyl amides, and ethylene oxide/propylene oxide block adducts. Specific examples of the anionic surfactant include a linear alkylbenzene sulfonate including an alkyl having 8 to 16 carbon atoms on average, an α-olefin sulfonate having 10 to 20 carbon atoms on average, a dialkyl sulfosuccinate including an alkyl group or an alkenyl group having 4 to 10 carbon atoms, a sulfonate of a fatty acid lower alkyl ester, an alkyl sulfate having 10 to 20 carbon atoms on average, an alkyl ether sulfate including a linear or branched alkyl group or alkenyl group having 10 to 20 carbon atoms on average and to which 0.5 to 8 mol of ethylene oxide on average is added, and a saturated or unsaturated fatty acid salt having 10 to 22 carbon atoms on average.

Examples of the pH adjusting agent include sodium borate, sodium carbonate, sodium silicate, sodium metasilicate, sodium succinate, and sodium acetate. Among them, sodium silicate is preferable from the viewpoint of solubility in water.

Examples of the cleaning aid include amines such as monoethanolamine, diethanolamine, and triethanolamine, ammonium salts such as tetramethylammonium hydroxide, and paraffinic hydrocarbons. By using the cleaning aid in combination with the surfactant and the PH adjusting agent, the cleaning ability can be enhanced.

These surfactants, pH adjusting agents, and cleaning aids are added to and mixed with water at an appropriate mixing ratio in the range of 0.1 to 50 mass%, and preferably 1 to 10 mass%, and then used.

After the development, the plate is typically dried in an oven for 15 to 120 minutes at about 60°C.

Depending on the composition of the photosensitive resin composition constituting the photosensitive resin layer, stickiness may remain on the plate surface even after drying is finished. In that case, stickiness can be removed by a known surface treatment method. As to such surface treatment method, exposure treatment with an active ray having a wavelength of 300 nm or less is desirable.

The photosensitive resin composition of the present invention is most suitable for use in letterpress printing using an oil-based ink containing an ester compound, such as printing of a fabric tag, but is not limited to this application, and can also be used for flexographic printing, planographic printing, intaglio printing, stencil printing, or photoresist.

### Examples

As hereunder, the effects of the present invention will be illustrated by referring to Examples although the present invention is not limited to those Examples. A term "part(s)" in Examples stand(s) for part(s) by mass, and values shown in Tables which indicate a composition ratio also stand for part(s) by mass.

### Examples 1 to 11 and Comparative Examples 1 to 3 (examples using latex as the polymer compound (A))

The components were blended so as to have the blending composition (parts by mass) listed in Table 1 and kneaded in a kneader at 100°C so as to prepare photosensitive resin compositions of Examples 1 to 11 and Comparative Examples 1 to 3.

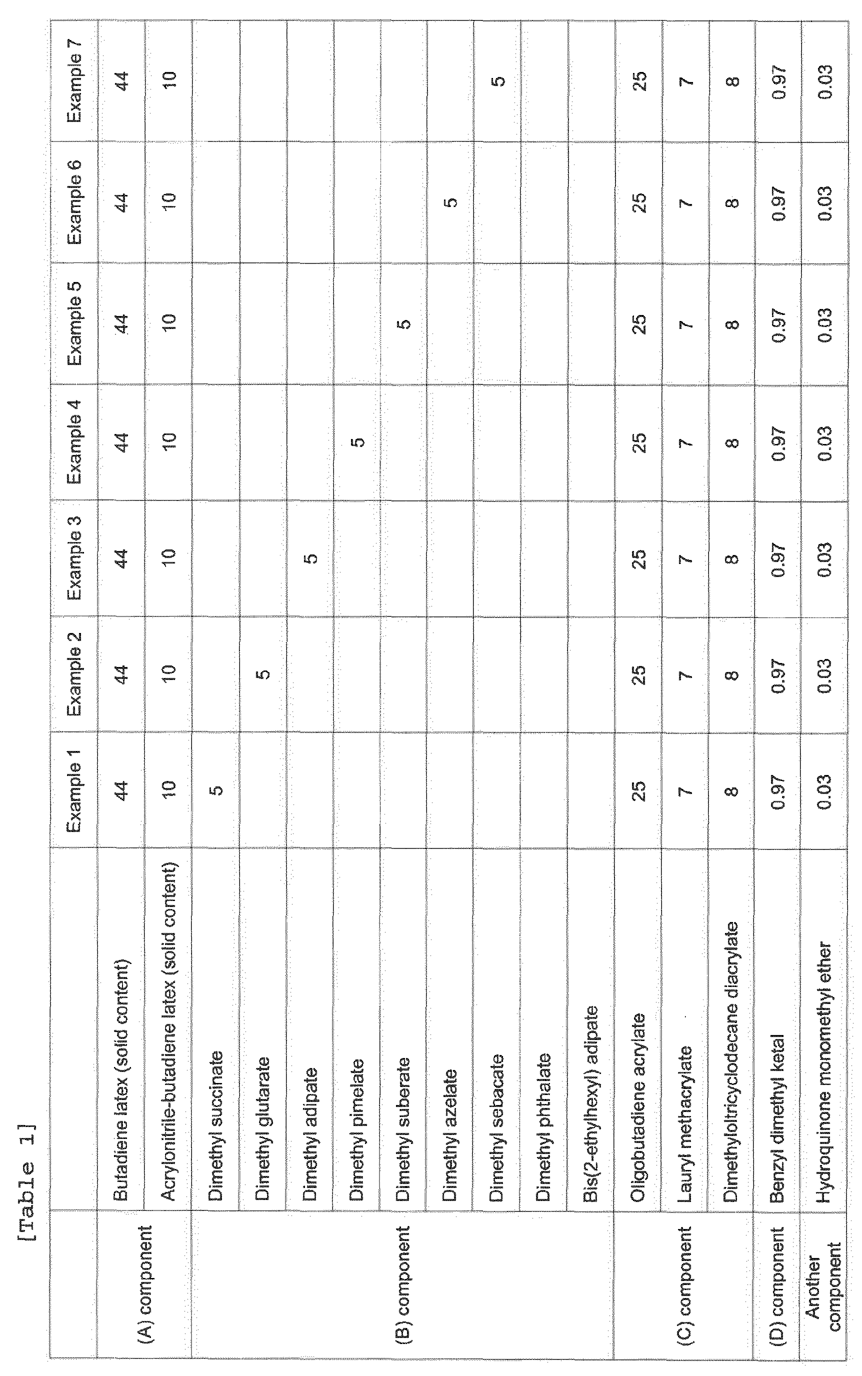

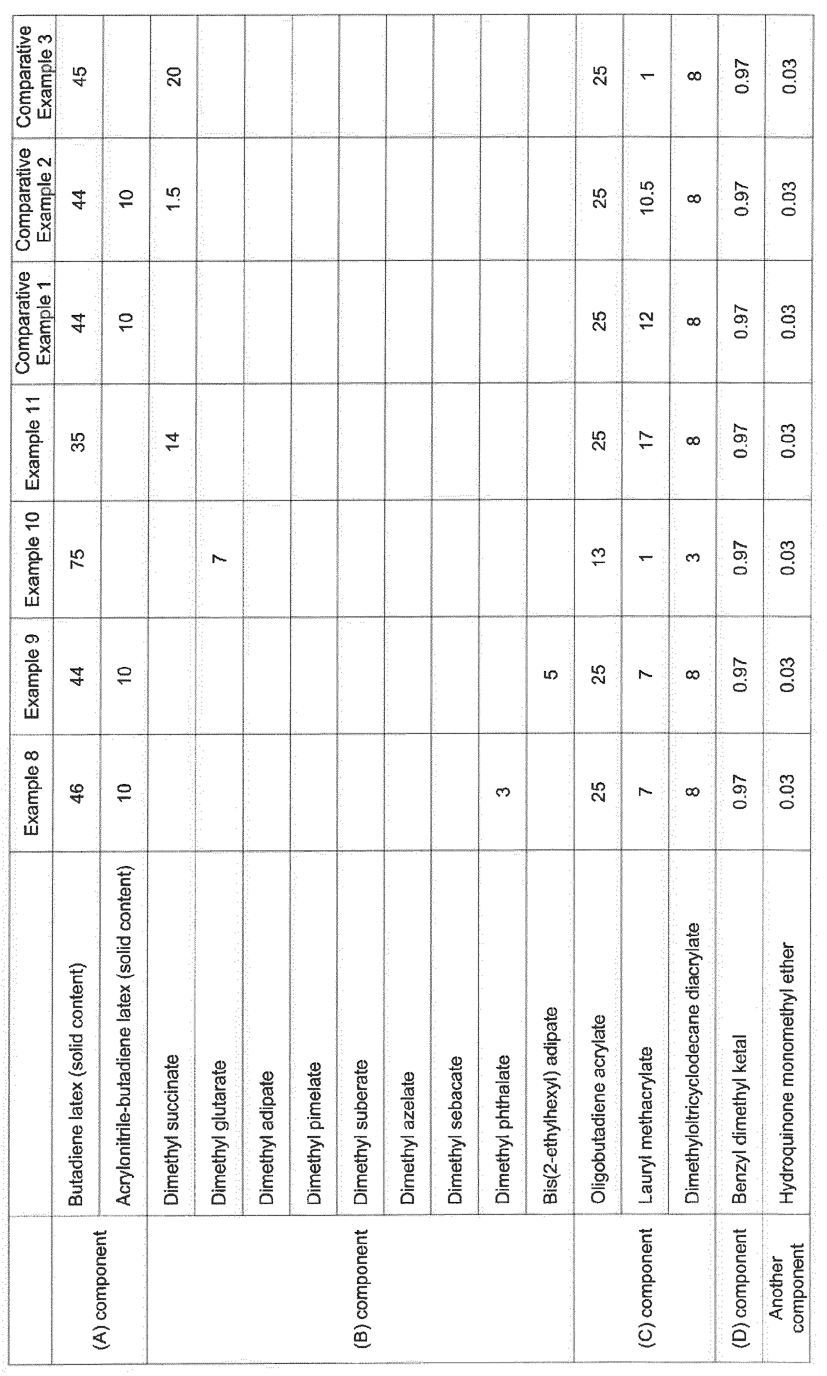

Details of each blended component used in Table 1 are as follows.

### Polymer compound (A)

- Butadiene latex (Nipol LX111NF, nonvolatile content 55%, manufactured by Zeon Corporation)
- Acrylonitrile-butadiene latex (Nipol SX1503, nonvolatile content 42%, manufactured by Zeon Corporation)

### Dibasic acid diester (B)

- Dimethyl succinate (manufactured by Tokyo Chemical Industry Co., Ltd.)
- Dimethyl glutarate (manufactured by Tokyo Chemical Industry Co., Ltd.)
- Dimethyl adipate (manufactured by Tokyo Chemical Industry Co., Ltd.)
- Dimethyl pimelate (manufactured by Tokyo Chemical Industry Co., Ltd.)
- Dimethyl suberate (manufactured by Tokyo Chemical Industry Co., Ltd.)
- Dimethyl azelate (manufactured by Tokyo Chemical Industry Co., Ltd.)
- Dimethyl sebacate (manufactured by Tokyo Chemical Industry Co., Ltd.)
- Dimethyl phthalate (manufactured by Tokyo Chemical Industry Co., Ltd.)
- Bis(2-ethylhexyl) adipate (manufactured by Tokyo Chemical Industry Co., Ltd.)

### Photopolymerizable compound (C)

- Oligobutadiene acrylate (ABU-4 manufactured by Kyoeisha Chemical Co., Ltd.)
- Lauryl methacrylate (LIGHT ESTER L manufactured by Kyoeisha Chemical Co., Ltd.)
- Dimethyloltricyclodecane diacrylate (LIGHT ACRYLATE DCP-A manufactured by Kyoeisha Chemical Co., Ltd.)

### Photopolymerization initiator (D)

- Benzyl dimethyl ketal (manufactured by Tokyo Chemical Industry Co., Ltd.)

### Another component

- Hydroquinone monomethyl ether (manufactured by Tokyo Chemical Industry Co., Ltd.)

The photosensitive resin composition of each of the examples and the comparative examples obtained as described above was sandwiched between a film obtained by coating a polyethylene terephthalate film having a thickness of 125 um with a polyester-based adhesive layer and a film obtained by coating the same polyethylene terephthalate film with an anti-tack layer (polyvinyl alcohol) so that the adhesive layer and the anti-tack layer are in contact with the photosensitive resin composition, and the product was pressed with a heat press machine at 105°C and a pressure of 100 kg/cm² for 1 minute so as to provide a printing original plate having a total thickness of 1.825 mm and comprising a photosensitive resin layer having a thickness of 1.7 mm.

Next, the produced printing original plate was subjected to a back exposure from a base side using an ultraviolet lamp (FR20T12-BL-9-BP, manufactured by Anderson & Vreeland) having an illuminance of 17.5 W/m² at 365 nm so that the relief depth was 0.8 mm. Thereafter, a step guide and a negative film including an image with convex characters T of an alphabet of 3 points, 5 points, and 10 points respectively and a solid image were applied to the original plate, and a main exposure step was performed such that the step guide reproduced 15 steps. Thereafter, the negative film was removed, a development step was performed with neutral water at 40°C containing 4 mass% of a sodium alkylnaphthalenesulfonate for 8 minutes, and the product was dried at 60°C for 10 minutes. Thereafter, a post-exposure step was performed for 5 minutes using the same ultraviolet lamp. Thereafter, the surface was treated by irradiation with a sterilization lamp for 5 minutes so as to provide a relief for evaluation.

### Examples 12 to 21 and Comparative Examples 4 to 6 (examples using polyamide resin or partially saponified polyvinyl acetate resin as the polymer compound (A))

The components were blended in a pot so as to have the blending composition (parts by mass) listed in Table 2, and concentrated until the temperature in the pot reached 110°C so as to prepare photosensitive resin compositions of Examples 12 to 21 and Comparative Examples 4 to 6.

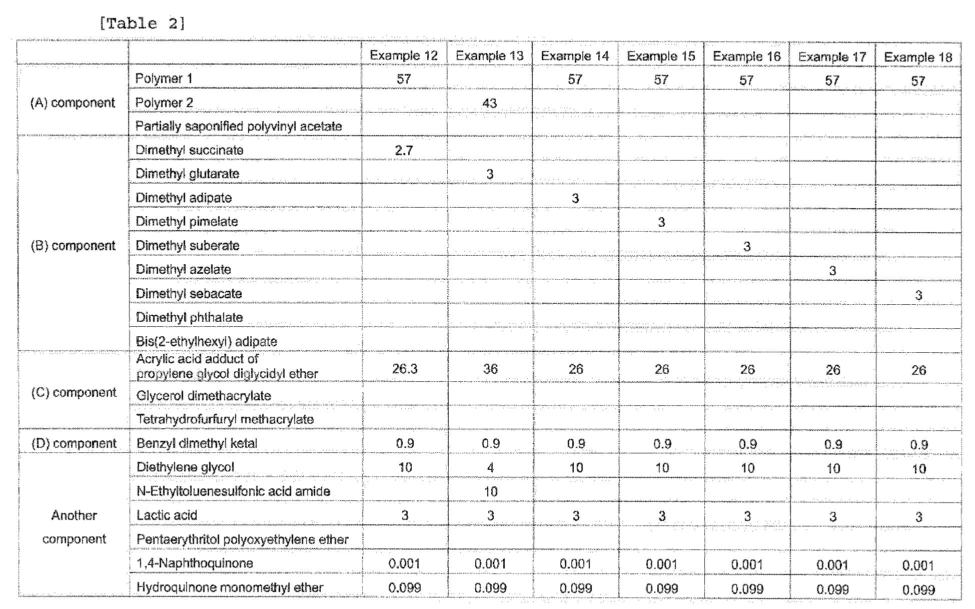

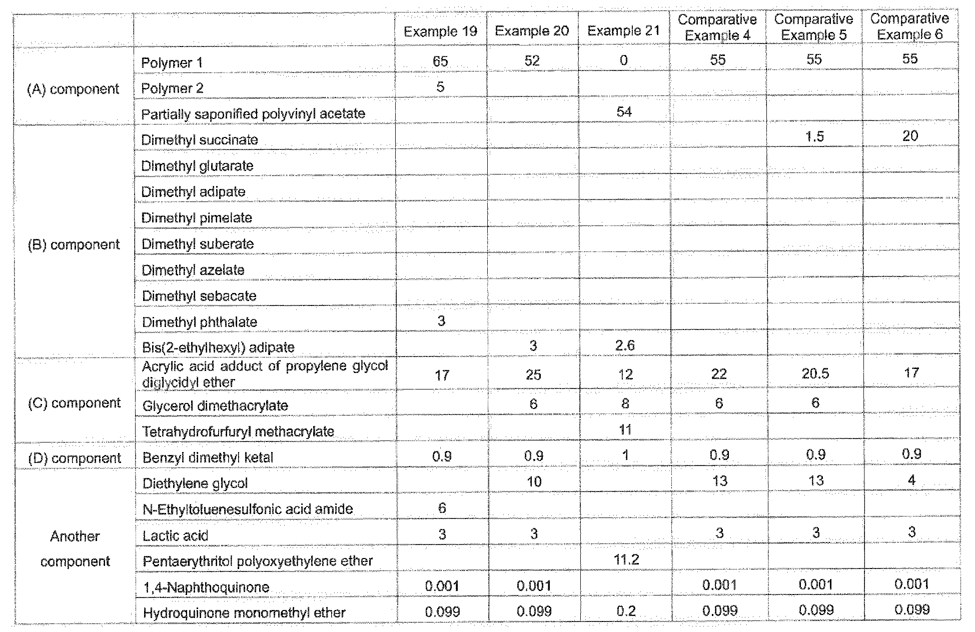

Details of each blended component used in Table 2 are as follows.

### Polymer compound (A)

- Polymer 1 synthesized by the following procedure
- Polymer 2 synthesized by the following procedure
- Partially saponified polyvinyl acetate (Gohsenol (trademark) KH-17 manufactured by Mitsubishi Chemical Corporation, saponification degree 78.5 to 81.5%, average polymerization degree 1,700)

### Dibasic acid diester (B)

- Dimethyl succinate (manufactured by Tokyo Chemical Industry Co., Ltd.)
- Dimethyl glutarate (manufactured by Tokyo Chemical Industry Co., Ltd.)
- Dimethyl adipate (manufactured by Tokyo Chemical Industry Co., Ltd.)
- Dimethyl pimelate (manufactured by Tokyo Chemical Industry Co., Ltd.)
- Dimethyl suberate (manufactured by Tokyo Chemical Industry Co., Ltd.)
- Dimethyl azelate (manufactured by Tokyo Chemical Industry Co., Ltd.)
- Dimethyl sebacate (manufactured by Tokyo Chemical Industry Co., Ltd.)
- Dimethyl phthalate (manufactured by Tokyo Chemical Industry Co., Ltd.)
- Bis(2-ethylhexyl) adipate (manufactured by Tokyo Chemical Industry Co., Ltd.)

### Photopolymerizable compound (C)

- Acrylic acid adduct of propylene glycol diglycidyl ether (EPOXY ESTER 70PA manufactured by Kyoeisha Chemical Co., Ltd.)
- Glycerol dimethacrylate (manufactured by Tokyo Chemical Industry Co., Ltd.)
- Tetrahydrofurfuryl methacrylate (LIGHT ESTER THF (100) manufactured by Kyoeisha Chemical Co., Ltd.)

### Photopolymerization initiator (D)

- Benzyl dimethyl ketal (manufactured by Tokyo Chemical Industry Co., Ltd.)

### Another component

- Diethylene glycol (manufactured by Tokyo Chemical Industry Co., Ltd.)
- N-Ethyltoluenesulfonic acid amide (manufactured by Tokyo Chemical Industry Co., Ltd.)
- Lactic acid (manufactured by Tokyo Chemical Industry Co., Ltd.)
- Pentaerythritol polyoxyethylene ether (manufactured by Nippon Nyukazai Co., Ltd.)
- 1,4-Naphthoquinone (manufactured by Tokyo Chemical Industry Co., Ltd.)
- Hydroquinone monomethyl ether (manufactured by Tokyo Chemical Industry Co., Ltd.)

### (Synthesis of polymer 1)

In a reactor, 50 parts of ε-caprolactam, 56 parts of N,N'-bis(γ-aminopropyl)piperazine adipate, 6.3 parts of 1,3-bisaminomethylcyclohexane adipate, and 10 parts of water were placed. After sufficient nitrogen purging, the reactor was sealed and gradually heated. When the internal pressure reached 10 kg/cm², the water in the reactor was gradually distilled, the reactor was returned to normal pressure in 1 hour, and then the reaction was carried out at normal pressure for 1.0 hour. The maximum polymerization temperature was 220°C. As a result, a transparent pale yellow alcohol-soluble oligomer was obtained. The oligomer had a specific viscosity of 1.5 and a number average molecular weight of about 3,000. Both ends of the oligomer were substantially primary amino groups and amide bonds were bonded in a block shape. After 46 parts of this oligomer was dissolved in 200 parts of methanol, 9 parts of an organic diisocyanate compound having isocyanate groups at substantially both ends was gradually added under stirring. The organic diisocyanate compound has been obtained by reacting 1,000 parts of polypropylene glycol (weight average molecular weight: 1,000) with 369 parts of hexamethylene diisocyanate. The reaction of the oligomer and the organic diisocyanate compound was completed at 65°C in about 15 minutes. This solution was placed on a Teflon (registered trademark) - coated petri dish, methanol was removed by evaporation, and the product was then dried under reduced pressure so as to provide a polyamide block copolymer (polymer 1). This polyamide block copolymer was a polymer compound having a specific viscosity of 2.0, containing 82 mass% of a block component of a structural unit constituted of amide bonds, and containing a urea bond and a urethane bond in addition to the amide bond.

### (Synthesis of polymer 2)

In a reactor, 55 parts of ε-caprolactam, 40 parts of N,N'-bis(y-aminopropyl)piperazine adipate, 7.5 parts of 1,3-bisaminomethylcyclohexane adipate, and 100 parts of water were placed. After sufficient nitrogen purging, the reactor was sealed and gradually heated. When the internal pressure reached 10 kg/cm², the water in the reactor was gradually distilled, the reactor was returned to normal pressure in 1 hour, and then the reaction was carried out at normal pressure for 1.0 hour, so as to obtain the polyamide (polymer 2). This polyamide had a specific viscosity of 2.4, and was a polymer compound composed of only the amide bond.

The photosensitive resin composition of each of the examples and the comparative examples obtained as described above was sandwiched between a film obtained by coating a polyethylene terephthalate film having a thickness of 125 µm with a polyester-based adhesive layer and a film obtained by coating the same polyethylene terephthalate film with an anti-tack layer (polyvinyl alcohol) so that the adhesive layer and the anti-tack layer are in contact with the photosensitive resin composition, so as to provide a printing original plate having a laminator total thickness of 1.825 mm and comprising a photosensitive resin layer having a thickness of 1.7 mm.

Next, the produced printing original plate was subjected to a back exposure from a base side using an ultraviolet lamp (FR20T12-BL-9-BP, manufactured by Anderson & Vreeland) having an illuminance of 17.5 W/m² at 365 nm so that the relief depth was 0.8 mm. Thereafter, a step guide and a negative film including an image with convex characters T of an alphabet of 3 points, 5 points, and 10 points respectively and a solid image were applied to the original plate, and a main exposure step was performed such that the step guide reproduced 15 steps. Thereafter, the negative film was removed, a development step was performed with tap water at 25°C for 3 minutes, and the product was dried by warm air at 70°C for 10 minutes. Thereafter, a post-exposure step was performed for 2 minutes using the same ultraviolet lamp so as to provide a relief for evaluation.

The printing original plates obtained from the photosensitive resin compositions of the examples and comparative examples were evaluated for image reproducibility, printability (line thickening), and printing durability (relief chipping resistance) by using the relief for evaluation. The results are shown in Table 3. The printability (line thickening) and printing durability (relief chipping resistance) were evaluated both in the case of tag printing using an oil-based ink containing an ester-based compound and in the case of flexographic printing using a water-based ink. A specific evaluation procedure is as follows.

### (Image reproducibility)

The image reproducibility was evaluated on the basis of the point size of the smallest convex character that could be reproduced. Specifically, one in which a 3-point convex character could be reproduced was classified as o, one in which a 5-point convex character could be reproduced was classified as Δ, one in which a 10-point convex character could be reproduced was classified as ×, and one in which a 10-point convex character could not be reproduced was classified as ××.

### (Printability and printing durability in the case of tag printing)

The relief for evaluation was printed on a tag printing machine (Shanghai Huanye Machine PT 2/1). Specifically, 8,000 m (50,000 shots) printing was performed using Fabrifast MIXING BLACK manufactured by Perfectos (an ink containing dimethyl succinate, dimethyl adipate, and dimethyl glutarate) as the oil-based ink and Nylon Taffeta as a substrate.

### (Printability)

The printability (line thickening) was evaluated on the basis of the ratio of the vertical line widths of 5-pt characters T of the printed matter after 100 shots and the printed matter after 50,000 shots. Specifically, those having a line width ratio of 1.0 or more and less than 1.5 were classified as ∘, those having a line width ratio of 1.5 or more and less than 2.0 were classified as Δ, those having a line width ratio of 2.0 or more were classified as ×, and those that could not be printed were classified as ××.

### (Printing durability)

The printing durability (chipping resistance of the relief) was evaluated on the basis of the presence or absence of chipping of the relief after 50,000 shot printing. Specifically, a sample having no relief chipping was classified as ∘, and a sample showing relief chipping was classified as ×.

### (Printability and printing durability in the case of flexographic printing)

The relief for evaluation was printed with a flexographic printer (FPR302 manufactured by MCK Co., Ltd.). Specifically, 8,000 m (50,000 shots) printing was performed using ROBOT INK manufactured by Inktech Limited (a propyl acetate-containing ink) as the oil-based ink and PPC50/OPT1/GB82 manufactured by Oji Tac Co., Ltd. as the substrate.

### (Printability)

The printability (line thickening) was evaluated on the basis of the ratio of the vertical line widths of 5-pt characters T of the printed matter after 100 shots and the printed matter after 50,000 shots. Specifically, those having a line width ratio of 1.0 or more and less than 1.5 were classified as ∘, those having a line width ratio of 1.5 or more and less than 2.0 were classified as Δ, those having a line width ratio of 2.0 or more were classified as ×, and those that could not be printed were classified as ××.

### (Printing durability)

The printing durability (chipping resistance of the relief) was evaluated on the basis of the presence or absence of chipping of the relief after 50,000 shot printing. Specifically, a sample having no relief chipping was classified as ∘, and a sample showing relief chipping was classified as ×.

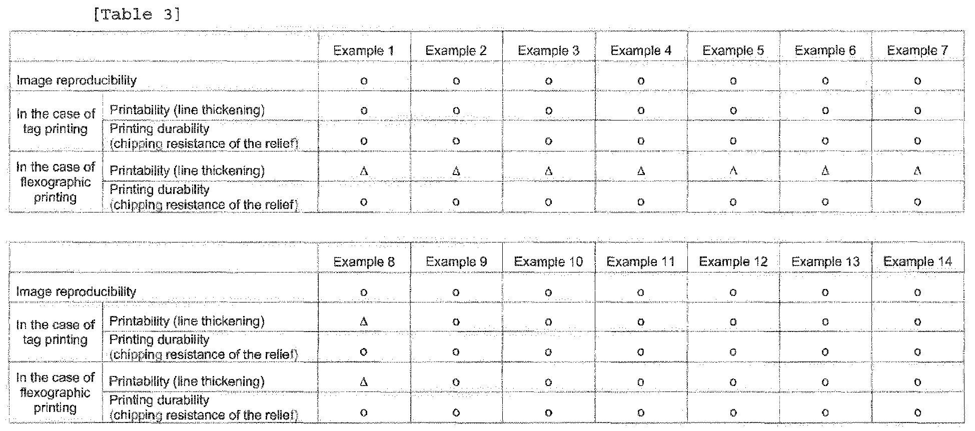

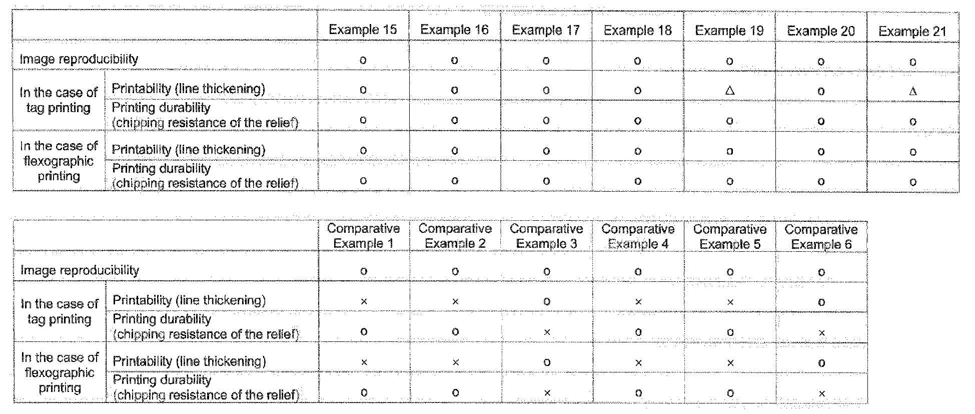

As can be seen from Table 3, all of Examples 1 to 21 satisfying the requirements of the present invention are excellent in the image reproducibility, printability (line thickening), and printing durability (relief chipping resistance). On the other hand, Comparative Examples 1 and 4 that do not contain the dibasic acid diester (B) at all and Comparative Examples 2 and 5 in which the content of the dibasic acid diester (B) is too small are inferior in the printability (line thickening). Comparative Examples 3 and 6 in which the content of the dibasic acid diester (B) is too large are inferior in the printing durability (relief chipping resistance).

### Industrial Applicability

In the printing plate obtained from the photosensitive resin printing original plate for letterpress printing of the present invention, the swelling of a printing plate due to absorption of the ink is small even when an oil-based ink containing an ester-based compound is used, and thus the line thickening of an image on a printed matter hardly occurs even when long-run printing is performed. Therefore, the present invention enables long-run printing in flexographic printing including tag printing and is expected to greatly contribute to the industry.

## Claims

1. A photosensitive resin printing original plate for letterpress printing having a photosensitive resin layer formed of a photosensitive resin composition containing at least a polymer compound (A), a dibasic acid diester (B) represented by the following general formula (I), a photopolymerizable compound (C), and a photopolymerization initiator (D), in which the content of the dibasic acid diester (B) in the photosensitive resin composition is 2.5 to 15 mass%: 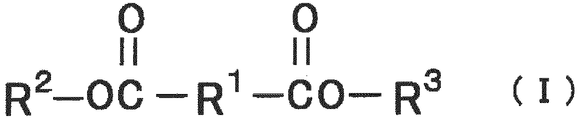 (where R¹ represents a divalent aliphatic hydrocarbon group having 2 to 8 carbon atoms, a divalent aromatic hydrocarbon group having 6 to 14 carbon atoms, or a divalent aliphatic cyclic hydrocarbon group having 4 to 14 carbon atoms, and R² and R³ may be the same as or different from each other and each represents a linear or branched aliphatic hydrocarbon group having 1 to 12 carbon atoms).

2. The photosensitive resin printing original plate for letterpress printing according to claim 1, wherein the dibasic acid diester (B) is at least one selected from the group consisting of succinic acid diester, glutaric acid diester, adipic acid diester, pimelic acid diester, suberic acid diester, azelaic acid diester, sebacic acid diester, and phthalic acid diester.

3. The photosensitive resin printing original plate for letterpress printing according to claim 1 or 2, wherein the polymer compound (A) is a latex having a butadiene skeleton and/or an isoprene skeleton.

4. The photosensitive resin printing original plate for letterpress printing according to claim 3, wherein the latex is a polybutadiene latex, a styrene-butadiene copolymer latex, an acrylonitrile-butadiene copolymer latex, a methyl methacrylate-butadiene copolymer latex, a polyisoprene latex, or a latex obtained by further copolymerizing acrylic acid or methacrylic acid with any of the above copolymer latexes.

5. The photosensitive resin printing original plate for letterpress printing according to claim 4, wherein the latex is at least one water-dispersible latex selected from the group consisting of a polybutadiene latex, a styrene-butadiene copolymer latex, an acrylonitrile-butadiene copolymer latex, a methyl methacrylate-butadiene copolymer latex, and a latex obtained by further copolymerizing acrylic acid or methacrylic acid with any of the above copolymer latexes.

6. The photosensitive resin printing original plate for letterpress printing according to claim 1 or 2, wherein the polymer compound (A) is a polyamide resin composed of a polyamide and/or a polyamide block copolymer, and/or a partially saponified polyvinyl acetate resin.
